# EUROPEAN PATENT APPLICATION

(11) **EP 4 818 728 A1**
(43) Date of publication of application: **07.10.2026**
(21) Application number: 26169823.7
(22) Date of filing: 31.03.2026
(51) Int. Cl.: G01R 31/69, B60L 53/16, H01R 13/66

(54) **CONNECTOR HEALTH MONITORING SYSTEM**

(30) Priority: 04.04.2025 US 202563783559 P; 26.06.2025 US 202519250596
(71) Applicant: TE Connectivity Solutions GmbH, 8200 Schaffhausen (CH)
(72) Inventor: VENKATESAN, Ram Kishore, Winston Salem 27101-2166 (US); SARRAF, David Bruce, Middletown 17057 (US); MYER, Nathan Philip, Middletown 17057 (US); ANGELL, Paul, Winston Salem 27101-2167 (US); HETRICK, Ryan, Middletown 17057 (US); HITCHCOCK, Matthew Bryan, Middletown 17057 (US); SHOEMAKER, Joshua T, Winston Salem 27101-2166 (US); RANGASWAMY, Rameshkumar, Winston Salem 27101-2166 (US); RHODES, Clara Marguerite, Winston Salem 27101-2166 (US); PATTERSON, Jeremy Christin, Winston Salem 27101-2166 (US)
(74) Representative: Ashton, Gareth Mark

(57) **Abstract**

A connector health monitoring system (70) for health assessment testing of an electrical connector (10) includes a connector health monitoring device (100) that includes a device housing (140) and a testing probe (110) held by the device housing and arranged at the mating end (112) for mating with a testable contact of the electrical connector to generate testing data. A communication module (166) transmits the testing data. The connector health monitoring system includes a health assessment device (200) communicatively coupled to the connector health monitoring device that receives the testing data from the communication module of the connector health monitoring device. The health assessment device includes an analyzer module (260) that includes a processor (165) for performing a health assessment of the electrical connector based on the testing data.

## Description

This application claims priority to US Application No. 63/783,559, filed 04-April-2025 and US Application No. 19/250,596 filed 26-June-2025, the subject matter of which is herein incorporated by reference in its entirety.

The subject matter herein relates to electrical connector health monitoring.

Electrical connectors are subject to wear and damage over time. For example, electrical connectors that are subject to numerous mate and unmate cycles and/or electrical connectors that are operated in harsh environments are subject to wear and damage over time. Additionally, the presence of foreign objects or debris at the separable connector interface is problematic and can lead to damage to the electrical connector components. Some known electrical connectors that suffer from such problems are charging connectors used for electrical charging. For example, the transition from Internal Combustion Engine (ICE) vehicles to Electric Vehicles (EVs) has introduced significant challenges in ensuring safe charging, particularly at the charging interface. This interface, where the vehicle connects to the charging station, is an example of a high voltage interface that is subjected to varying amounts of environment exposure and therefore is susceptible to damage or degradation in the field. Charging components are made robust to handle charging plugs of varying quality and conditions. There is a need to develop solutions for sensing the health of the connection systems to enable predictive maintenance. One of the major implications of a bad connection is an increase in heat loss which reduces the overall charging efficiency. The decrease in charging efficiency translates to an increase in charging power or duration. This increased cost due to a bad connection is charged back to the vehicle owner and it results in poor experience for the end user. In certain cases, the bad connection can also result in irreversible damage on the vehicle inlets that would require servicing or replacement. All the above factors reiterate the ever increasing need to detect and enable routine maintenance of the charging plugs and separable interfaces that are out in the field that are susceptible to damage from exposure to contaminants. Other types of connectors other than charging connectors suffer from similar deterioration and need for maintenance.

There is a need for a connector health monitoring system that provides a reliable way of assessing connector health at separable mating interfaces.

In an embodiment, a connector health monitoring system for health assessment testing of an electrical connector is provided. The connector health monitoring system includes a connector health monitoring device that includes a device housing and a testing probe held by the device housing. The device housing includes a mating end configured for mating with the electrical connector. The testing probe is arranged at the mating end for mating with a testable contact of the electrical connector to generate testing data. The connector health monitoring device includes a communication module configured to transmit the testing data. The connector health monitoring system includes a health assessment device communicatively coupled to the connector health monitoring device. The health assessment device includes a communication module configured to receive the testing data from the communication module of the connector health monitoring device. The health assessment device includes an analyzer module that includes a processor for performing a health assessment of the electrical connector based on the testing data. The electrical connector may be a charging connector for an electric vehicle and the testable contact may be a charging contact.

The figures will be described by way of example with reference to the accompanying Figures of which:
Figure 1 illustrates a connector health monitoring system in accordance with an exemplary embodiment.
Figure 2 is a front view of the connector health monitoring device in accordance with an exemplary embodiment.
Figure 3 is a rear view of the connector health monitoring device in accordance with an exemplary embodiment.
Figure 4 is an exploded view of the connector health monitoring device in accordance with an exemplary embodiment.
Figure 5 is a front perspective view of the connector health monitoring device in accordance with an exemplary embodiment.
Figure 6 is a rear perspective view of the connector health monitoring device shown in Figure 5 in accordance with an exemplary embodiment.
Figure 7 is a front view of the health assessment device in accordance with an exemplary embodiment.
Figure 8 illustrates the connector health monitoring system in accordance with an exemplary embodiment.

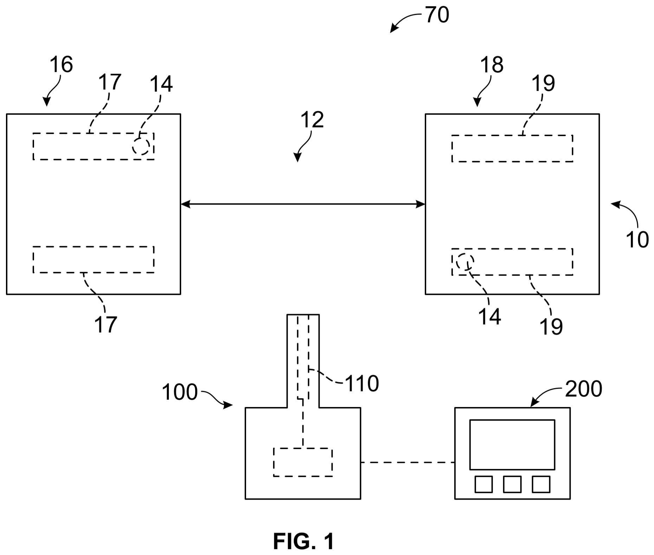

Figure 1 illustrates a connector health monitoring system 70 in accordance with an exemplary embodiment. The connector health monitoring system 70 includes a connector health monitoring device 100 and a health assessment device 200. The health assessment device 200 is separate and discrete from the connector health monitoring device 100. The connector health monitoring device 100 is communicatively coupled to the health assessment device 200. For example, the connector health monitoring device 100 may communicate wirelessly with the health assessment device 200. The connector health monitoring device 100 is used for monitoring or testing one or more electrical connectors 10. The health assessment device 200 is used for analyzing the testing data generated by the connector health monitoring device 100 for determining a health assessment of the electrical connector 10 based on the testing data.

The connector health monitoring system 70 is used for assessing health of the mating interface of one or more electrical connectors 10. For example, the connector health monitoring system 70 may assess health of a separable connector interface 12 of the electrical connector(s) 10, such as for foreign object debris (FOD) 14 and/or for wear of the contacts or terminals thereof and/or to assess operational status of the contacts or terminals thereof. The connector health monitoring system 70 provides the health assessment to the user and/or to a network of interested parties, such as to identify the health or operability of the particular electrical connector(s) 10. For example, the user or interested parties may schedule maintenance or repair of the electrical connector(s) 10 based on the health assessment. The connector health monitoring system 70 may facilitates scheduling proactive maintenance and reduces downtime of components, such as the charging device of a charging system. The user or interested parties may utilize other electrical connector(s) 10 based on the health assessment. The health assessment may be indicated at the health assessment device 200 or may be more widely distributed, such as to another remote device(s), computers, servers, network, cloud, or other recipient.

In an exemplary embodiment, the electrical connectors 10 at the separable connector interface 12 include a first electrical connector 16 and a second electrical connector 18. The connector health monitoring system 70 may be used to test the interface of the first electrical connector 16 and/or the second electrical connector 18. In an exemplary embodiment, the connector health monitoring system 70 is used to test electrical terminals or contacts 17 of the first electrical connector 16 and/or electrical terminals or contacts 19 of the second electrical connector 18. For example, the connector health monitoring device 100 may be mated with the first electrical connector 16 and/or the second electrical connector 18 for health assessment of the corresponding electrical connectors 16, 18.

In an exemplary embodiment, the connector health monitoring device 100 includes one or more testing probes 110 configured to be mated with the testable contacts of the electrical connector(s) 10 at the separable connector interface 12. The testing probe 110 may be plugged into the interface of the first electrical connector 16 and/or the second electrical connector 18. For example, the testing probe 110 may be mated with the electrical terminals 17 of the first electrical connector 16 and/or the electrical terminals 19 of the second electrical connector 18 for testing the electrical terminals 17, 19.

In an exemplary embodiment, the connector health monitoring device 100 may include one or more testing probes 110. Each testing probe 110 may be used to measure one or more health assessment characteristics of the testable contact and/or the electrical connector 10 at the separable connector interface 12. For example, the health assessment characteristics may include mating force, electrical characteristics, contact resistance, contact wear, emissivity, contact size, contact shape, presence of FOD, and the like. Optionally, multiple testing probes 110 may be provided for testing different health assessment characteristics and/or for testing different electrical terminals or different areas of the separable connector interface 12. In an exemplary embodiment, the testing arrangement is configured for multi-parameter health assessment analysis of the separable connector interface 12.

The testing data from the testing probes 110 is configured to be communicated to the health assessment device 200, such as by wireless communication. The communication may be short range, such as via Bluetooth or Wi-Fi communication between the connector health monitoring device 100 and the health assessment device 200, such as when the health assessment device 200 is in the vicinity of the connector health monitoring device 100 (for example, both devices at the location of the electrical connector 10). In other various embodiments, the communication may be configured for long range communication when the connector health monitoring device 100 and the health assessment device 200 are in different locations, such as via cellular wireless communication over a cellular network. After the health assessment device 200 receives the testing data, the health assessment device 200 performs the health assessment to make a determination of quality or operation status of the electrical connector 10 based on the testing data. In various embodiments, the raw test data may be transmitted to the health assessment device 200 from the connector health monitoring device 100. For example, the testing data may be transmitted without being processed. However, in other various embodiments, the connector health monitoring device 100 may include one or more processors configured to process the testing data and the processed testing data is transmitted to the health assessment device 200 for analysis and a determination of the health assessment of the connectors by the health assessment device 200.

In various embodiments, the connector health monitoring device 100 is a handheld device. For example, the connector health monitoring device 100 may be a handheld, pluggable device configured to be plugged into or mated with the electrical connector 10. In other various embodiments, the connector health monitoring device 100 may be incorporated into another component, such as a system component associated with the electrical connector 10 for testing the electrical connector 10 during a testing process. The connector health monitoring device 100 may be integrated with the electrical connector 16 for testing the electrical connector 18, or vice versa. The connector health monitoring device 100 may be integrated into an assembly robot, such as into an end effector at an end of an arm of the robot for testing the electrical connector 10, such as immediately after assembly of the electrical connector 10.

In various embodiments, the connector health monitoring system 70 is used for assessing the health of power connectors, such as connectors used in charging applications. For example, the connector health monitoring system 70 may be used for assessing health of charging plugs and/or charging inlets of vehicles, such as electric vehicles. However, the connector health monitoring system 70 is not limited to use with charging applications or power connectors, but rather may be used with other types of electrical connectors in various other applications.

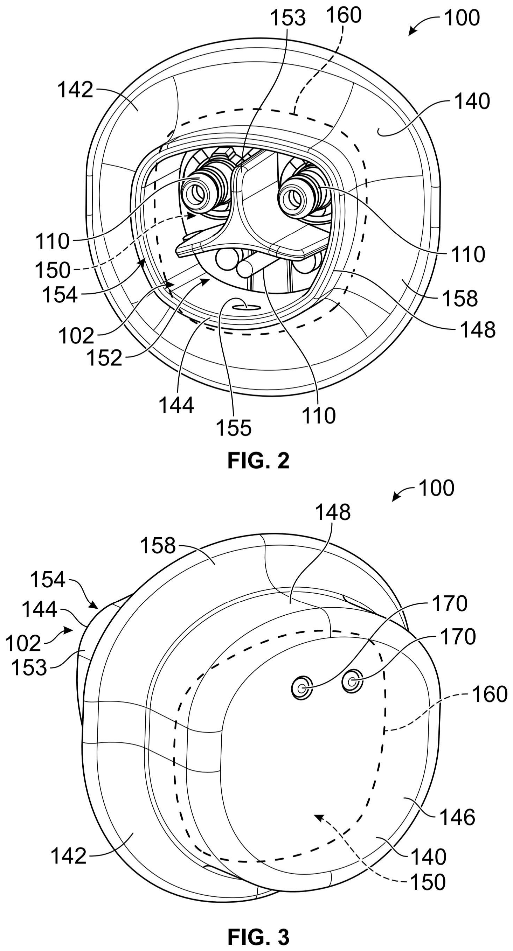

Figure 2 is a front view of the connector health monitoring device 100 in accordance with an exemplary embodiment. Figure 3 is a rear view of the connector health monitoring device 100 in accordance with an exemplary embodiment. The connector health monitoring device 100 includes a mating interface 102 configured to be mated with the electrical connector 10 during a testing operation. The mating interface 102 is sized and shaped to interface with the electrical connector 10. In various embodiments, the mating interface 102 may have a standard interface for mating with the electrical connector 10. For example, the mating interface 102 may have a standard power charging interface, such as for an electric vehicle. However, the connector health monitoring device 100 is not limited to testing power charging interfaces of an electric vehicle. In various embodiments, the mating interface 102 may mimic a mating interface of a charging inlet of an electric vehicle such that the connector health monitoring device mimics the mating interface of a charging inlet of an electric vehicle for testing a charging plug of a charging station. For example, the mating interface 102 may be a CCS1 charging interface, a NACS charging interface, or another type of standard charging interface for electric vehicle.

The connector health monitoring device 100 includes a device housing 140 holding one or more of the testing probes 110. The device housing 140 holds a control element 160 operably coupled to the testing probes 110. The control element 160 may include one or more processors for processing the testing data. The control element 160 may include one or more sensors associated with the testing probes for receiving the testing data. In an exemplary embodiment, the connector health monitoring device 100 may include one or more indicators 170 operably coupled to the control element 160. The indicators 170 may provide a visual indication, audible indication, or other type of indication to the operator indicative of the connector health of the electrical connector 10 during the testing operation. For example, the indicators 170 may include LED lights to provide a visual indication to the operator, such as a green light and a red light to indicate good health or poor health, respectively. Other types of indicators may be used in alternative embodiments.

The device housing 140 includes a body 142 extending between a front 144 and a rear 146 of the device housing 140. In the illustrated embodiment, the indicators 170 are provided at the rear 146. Other locations are possible in alternative embodiments. In an exemplary embodiment, the body 142 may be manufactured from a dielectric material, such as a plastic material. For example, the body 142 may be a molded part, such as an injection molded part. The body 142 may be a multipiece body having multiple pieces coupled together to form the device housing 140. The body 142 includes walls 148 surrounding a cavity 150. The control element 160 is received in the cavity 150. The testing probes 110 may extend into the cavity 150. Other components may be housed within the cavity 150 and surrounded by the body 142. In various embodiments, the cavity 150 may be enclosed, such as being entirely surrounded by the body 142. In various embodiments, the body 142 may be sealed to provide a sealed environment for the components held within the cavity 150.

In an exemplary embodiment, the walls 148 form a socket or receptacle 152 configured to receive a portion of the electrical connector 10. In the illustrated embodiment, the receptacle 152 is located at the front 144. The testing probes 110 are located within the receptacle 152. For example, the testing probes 110 may be surrounded by the walls 148 forming the receptacle 152. In alternative embodiments, the testing probes 110 may extend forward of the device housing 140. In an exemplary embodiment, the device housing 140 includes a separating wall 153 extending into the receptacle 152 that separates the receptacle 152 into different chambers. Each of the chambers may receive the corresponding testing probe 110. For example, the separating wall 153 separates the testing probes 110 from each other. Optionally, multiple testing probes 110 may be located in each chamber. The walls 148 and/or the separating wall 153 may include keying features, alignment features, or other types of locating features to guide mating with the electrical connector 10.

In an exemplary embodiment, the device housing 140 includes a mating end 154 configured to be mated with the electrical connector 10. In the illustrated embodiment, the mating end 154 is located at the front 144. Other locations are possible in alternative embodiments. In various embodiments, the device housing 140 may include multiple mating ends configured to be mated to different types of electrical connectors 10. For example, the mating ends may be provided at the front 144 and the rear 146 for mating with different electrical connectors 10. In an exemplary embodiment, the device housing 140 includes one or more latching mechanisms 155 for latching engagement with the electrical connector 10. In various embodiments, the latching mechanisms 155 may be deflectable latches. Other types of latching mechanisms may be used in alternative embodiments, such as a fixed latch mechanism, a catch, a clip, or other type of latching mechanism. In alternative embodiments, other types of securing means, such as fasteners, straps, clips, locks, and the like may be used to secure the device housing 140 to the electrical connector 10.

In an exemplary embodiment, the device housing 140 includes a handle 158 for holding the device housing 140. The handle 158 may extend from one or more the sides of the device housing 140. The handle 158 may extend from the front 144 and/or the rear 146. In the illustrated embodiment, the handle 158 is formed by a circumferential flange that extends radially outward from the device housing 140, such as at the sides, the top, and the bottom thereof. Other locations are possible in alternative embodiments. The handle 158 may include finger grips or other features to allow the user to hold the device housing 140.

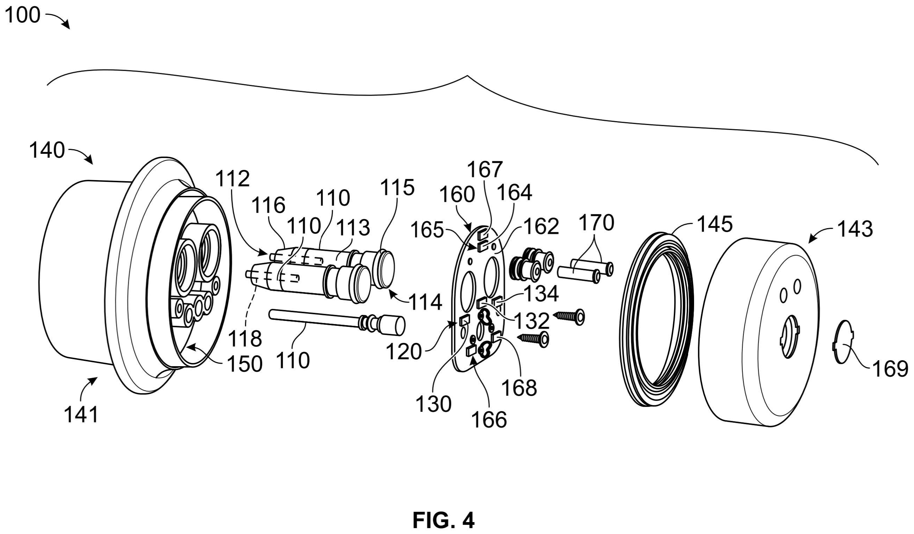

Figure 4 is an exploded view of the connector health monitoring device 100 in accordance with an exemplary embodiment. Figure 4 shows the device housing 140, the testing probes 110, and the control element 160 in accordance with an exemplary embodiment. The control element 160 and the testing probes 110 may be held by the device housing 140.

In the illustrated embodiment, the device housing 140 is a multipiece housing including a front housing 141 and the rear housing 143 configured to be coupled together. In an exemplary embodiment, a peripheral seal 145 is configured to be located between the front housing 141 and the rear housing 143 to provide a sealed interface between the front housing 141 and the rear housing 143 the peripheral seal 145 is configured to seal the cavity 150.

Each testing probe 110 extends between a mating end 112 and a terminating end 114. The mating end 112 includes a mating interface 113 configured to be mated with the testable contact of the electrical connector 10. Optionally, the testing probe 110 may have a graphite layer or other low wear layer to improve wear resistance of the connector interface and extend the life of the electrical connector 10 and/or the testing device, which may reduce maintenance frequency. The terminating end 114 is configured to be electrically connected to the control element 160. In various embodiments, the testing probe 110 may include a probe seal 115 at the terminating end 114 configured to be sealed to the device housing 140 or other component within the device housing 140. In the illustrated embodiment, the testing probes 110 are pins at the mating end 112. In alternative embodiments, the testing probes 110 may be sockets at the mating end 112. Other types of testing probes may be used in alternative embodiments. In various embodiments, the testing probes 110 may include touch proof caps 116 at the mating end 112 to prevent inadvertent touching of the mating end 112. The testing probes 110 may be cylindrical, such as having a diameter. In various embodiments, the diameter may be equal to a diameter of a charging pin for a charging inlet of an electric vehicle such that the connector health monitoring device mimics the mating interface of a charging inlet of an electric vehicle for testing a charging plug of a charging station.

The control element 160 is configured to be held by the device housing 140 and may be received in the cavity 150, such as between the front housing 141 and the rear housing 143. The control element 160 is configured to be operably coupled to the testing probes 110 and receives signals from the testing probes 110 and/or transmit signals to the testing probes 110. In an exemplary embodiment, the control element 160 includes circuitry or components for processing the signals or testing data from the testing probes 110. The control element 160 may include circuitry or components for measuring and/or analyzing the testing data. The control element 160 may include circuitry or components for performing a health assessment of the electrical connector 10 during the testing operation.

In an exemplary embodiment, the control element 160 includes a printed circuit board 162, a control module 164 mounted to the printed circuit board 162 and a communication module 166 coupled to the printed circuit board 162. The control element 160 may include a geolocation element 167 to identify a location of the connector health monitoring device 100 during testing, such as using GPS or other location based tracking device, such as to identify the location of the electrical connector being tested. In an exemplary embodiment, the control element 160 may include a battery 168 for powering one or more components of the control element 160. The battery 168 is configured to be positioned in the cavity 150 of the device housing 140. The battery 168 may be rechargeable. The battery 168 may be accessed through the rear housing 143. The battery 168 may be covered by a battery cover 169, which may be removable, such as for charging of the battery 168.

In an exemplary embodiment, the indicators 170 are coupled to the printed circuit board 162. Other types of output devices, such as a user interface (not shown) may be coupled to the printed circuit board 162 to provide output to the user. The indicators 170 may pass through openings in the device housing 140, such as the rear housing 143. The indicators 170 may include LEDs to provide visual indication to the user. Other types of indicators may be used in alternative embodiments.

The printed circuit board 162 includes a substrate having one or more layers. The printed circuit board 162 includes circuits including conductors printed on one or more layers of the substrate. The circuits may include conductors, traces, vias, pads, or other type of circuit elements. One or more electrical components may be coupled to the circuits. In an exemplary embodiment, the testing probes 110 are terminated to the printed circuit board 162. For example, the testing probes 110 may be soldered to circuits of the printed circuit board 162 or connected via contacts to the printed circuit board 162. The substrate of the printed circuit board 162 may be secured to the device housing 140, such as using fasteners.

In an exemplary embodiment, the testing probes 110 are coupled to the printed circuit board 162. The testing probes 110 may be communicatively coupled to one or more testing sensors 120. For example, the testing sensors 120 may receive signals from the testing probes 110. The signals may be transmitted through one or more circuits of the printed circuit board 162. The testing probes 110 may be separate components from the testing sensors 120 and/or the control module 164. In alternative embodiments, the testing sensors 120 may be integrated with the control module 164 or the testing probes 110. The testing probes 110 and/or the testing sensors 120 are used to measure one or more health assessment characteristics of the testable contact and/or the electrical connector 10 at the separable connector interface 12. For example, the health assessment characteristics may include mating force, electrical characteristics, contact resistance, contact wear, emissivity, contact size, contact shape, presence of FOD, and the like. Optionally, multiple testing probes 110 and/or the testing sensors 120 may be provided for testing different health assessment characteristics and/or for testing different electrical terminals or different areas of the separable connector interface 12. In an exemplary embodiment, the testing arrangement is configured for multi-parameter health assessment analysis of the separable connector interface 12. The testing sensor 120 may be a force sensor configured to measure mating forces at the testing probe 110. The testing sensor 120 may be an electrical sensor configured to measure current, voltage, amperage, and the like. The testing sensor 120 may be a proximity sensor configured to measure proximity and/or distance to the testable contact or other component of the electrical connector. The testing sensor 120 may be an image sensor configured to analyze digital images or other types of images.

The control module 164 includes one or more electrical components, such as processors, IC components, memory devices, a CMOS sensor, a field programmable gate array (FPGA), a digital signal processor (DSP), and the like. For example, the control module 164 includes one or more processors 165 for processing the testing data. In an exemplary embodiment, the control module 164 may be programmable. For example, the control module 164 may receive over-the-air update signals, such as to update the analysis software or algorithms. During operation, the control module 164 may run programs to process the testing data and/or analyze the testing data, such as for health assessment. For example, the control module 164 operates programs stored in one or more memories on the processor 165. The data analysis may be used to allow/disallow connection or operation of the electrical connector, for scheduled maintenance, to evaluate efficiency (for example, power conversion efficiency to predict charging time based on use of the electrical connector 10).

The processor(s) 165 may include computer system executable instructions, such as program modules, being executed by a computer system. Generally, program modules may include routines, programs, objects, components, logic, data structures, and so on that perform particular tasks or implement particular abstract data types. The computing may be practiced in distributed cloud computing environments where tasks are performed by remote processing devices that are linked through a communications network. In a distributed cloud computing environment, program modules may be located in both local and remote computer system storage media including memory storage devices.

In an exemplary embodiment, various components may be communicatively coupled by a bus, such as the memory and the processors 165. The bus represents one or more of any of several types of bus structures, including a memory bus or memory controller, a peripheral bus, an accelerated graphics port, and a processor or local bus using any of a variety of bus architectures.

The control module 164 may include a variety of computer system readable media. Such media may be any available media that is accessible by the control module 164, and it includes both volatile and non-volatile media, removable and non-removable media. The memory can include computer system readable media in the form of volatile memory, such as random access memory (RAM) and/or cache memory. The control module 164 may further include other removable/non-removable, volatile/non-volatile computer system storage media. By way of example only, a storage system can be provided for reading from and writing to a non-removable, non-volatile magnetic media (not shown and typically called a "hard drive"). Although not shown, a magnetic disk drive for reading from and writing to a removable, non-volatile magnetic disk (e.g., a "floppy disk"), and an optical disk drive for reading from or writing to a removable, non-volatile optical disk such as a CD-ROM, DVD-ROM or other optical media can be provided. In such instances, each can be connected to the bus by one or more data media interfaces. The memory may include at least one program product having a set (e.g., at least one) of program modules that are configured to carry out the functions of embodiments of the invention.

One or more programs may be stored in the memory, as well as an operating system, one or more application programs, other program modules, and program data. Each of the operating system, one or more application programs, other program modules, and program data or some combination thereof, may include an implementation of a networking environment. Program modules generally carry out the functions and/or methodologies of embodiments of the subject matter described herein.

The control module 164 may also communicate with one or more external devices, such as through the communication module 166 of the control module 164, for data sharing and/or analysis by remote testing devices. In an exemplary embodiment, the communication module 166 communicates with the health assessment device 200. For example, the communication module 166 may transmit the testing data to the health assessment device 200. The communication module may transmit the raw/unprocessed testing data or may transmit processed testing data. The communication module 166 may communicate with the electrical connector 10 or the system incorporating the electrical connector 10 (for example, the charging station or the electric vehicle). The communication module 166 may communicate with the user, such as through a mobile device (for example, cell phone app or vehicle display system). In various embodiments, the communication module 166 is configured to communicate wirelessly, such as via Bluetooth, Wi-Fi, cellular, or other wireless protocol. In other various embodiments, the communication module 166 may communicate through the testing probes 110 or other contacts, such as to the electrical connector 10. The health data or other signals may be shared with the electrical connector, or the system associated with the electrical connector, for maintenance or to alert other users of the health of the electrical connector. The external devices may include a keyboard, a pointing device, a display, and the like; one or more devices that enable a user to interact with system; one or more mobile devices (such as a mobile phone or mobile testing unit); one or more devices associated with the electrical connector 10 (such as the charging station, the electric vehicle, and the like); and/or any devices (e.g., network card, modem, etc.) that enable the system to communicate with one or more other computing devices. Such communication can occur via Input/Output (I/O) interfaces. Still yet, the control module 164 can communicate with one or more networks such as a local area network (LAN), a general wide area network (WAN), and/or a public network (e.g., the Internet) via network adapter. Other hardware and/or software components could be used in conjunction with the system components shown herein. Examples include, but are not limited to: microcode, device drivers, redundant processing units, and external disk drive arrays, RAID systems, tape drives, and data archival storage systems, etc.

The term "processor" as used herein is intended to include any processing device, such as, for example, one that includes a CPU (central processing unit) and/or other forms of processing circuitry. Further, the term "processor" may refer to more than one individual processor. The term "memory" is intended to include memory associated with a processor or CPU, such as, for example, RAM (random access memory), ROM (read only memory), a fixed memory device (for example, hard drive), a removable memory device (for example, diskette), a flash memory and the like. In addition, the phrase "input/output interface" as used herein, is intended to contemplate an interface to, for example, one or more mechanisms for inputting data to the processing unit (for example, mouse), and one or more mechanisms for providing results associated with the processing unit (for example, printer). The processor, memory, and input/output interface can be interconnected, for example, via the bus as part of a data processing unit. Suitable interconnections, for example via bus, can also be provided to a network interface, such as a network card, which can be provided to interface with a computer network, and to a media interface, such as a diskette or CD-ROM drive, which can be provided to interface with suitable media.

Accordingly, computer software including instructions or code for performing the methodologies of the subject matter herein may be stored in one or more of the associated memory devices (for example, ROM, fixed or removable memory) and, when ready to be utilized, loaded in part or in whole (for example, into RAM) and implemented by a CPU. Such software could include, but is not limited to, firmware, resident software, microcode, and the like.

It should be noted that any of the methods described herein can include an additional step of providing a system comprising distinct software modules embodied on a computer readable storage medium; the modules can include, for example, any or all of the appropriate elements depicted in the block diagrams and/or described herein; by way of example and not limitation, any one, some or all of the modules/blocks and or sub-modules/sub-blocks described. The method steps can then be carried out using the distinct software modules and/or sub-modules of the system, as described above, executing on one or more hardware processors. Further, a computer program product can include a computer-readable storage medium with code adapted to be implemented to carry out one or more method steps described herein, including the provision of the system with the distinct software modules.

In an exemplary embodiment, the testing probe 110 includes a pogo pin 118 for mating with the separable connector interface 12, such as the testable contact of the electrical connector 10. The testing probe 110 may include other types of testing elements in alternative embodiments. In an exemplary embodiment, the testing probe 110 may be removable and replaceable. For example, the testing probe 110 may be threadably coupled to the device housing 140 and/or the control module 164 to allow removal and replacement of the testing probe 110. The testing probe 110 may be removed and replaced for testing different separable connector interfaces. For example, different sized (length and/or diameter) testing probes 110 may be used. Testing sensors having different types of testing elements may be utilized by removing and replacing the different testing probes 110.

In an exemplary embodiment, the testing sensors 120 associated with the testing probe 110 includes a force measurement sensor 130 for sensing mating force with the separable connector interface 12. The force measurement sensor 130 may sense a compression force of the pogo pin 118, such as to detect for FOD. Data from the force measurement sensor 130 may be transmitted by the communication module 166, such as to the health assessment device 200 as testing data or sensor data.

In an exemplary embodiment, the testing sensors 120 associated with the testing probe 110 includes an electrical resistance measurement sensor 132 for sensing electrical resistance with the separable connector interface 12, such as the testable contact. The electrical resistance measurement sensor 132 senses electrical resistance between the pogo pin 118 and the testable contact. Data from the electrical resistance measurement sensor 132 may be transmitted by the communication module 166, such as to the health assessment device 200 as testing data or sensor data.

In an exemplary embodiment, the testing sensors 120 associated with the testing probe 110 includes a position measurement sensor 134 for sensing a mated position of the testing probe 110 with the separable connector interface 12. The position measurement sensor 134 may include at least one of an optical sensor, a laser measurement sensor, and a proximity sensor for sensing the mated position of the testing probe 110 with the separable connector interface 12. The position measurement sensor 134 may detect a position of the testing probe 110 relative to the testable contact and/or the housing of the electrical connector 10, such as the position of the pogo pin 118. The position measurement sensor 134 may detect a length of the pogo pin 118 and/or an amount of compression of the pogo pin 118. Data from the position measurement sensor 134 may be transmitted by the communication module 166, such as to the health assessment device 200 as testing data or sensor data.

In an exemplary embodiment, the testing probe 110 is mated with the separable connector interface 12 to a mated position. An amount of compression of the pogo pin 118 at the mated position may be different when FOD is present compared to when no foreign object is present at the separable connector interface 12. In an exemplary embodiment, the pogo pin 118 is configured to be electrically connected to an electrical terminal 17 at the separable connector interface 12. A measurement of electrical resistance between the pogo pin 118 and the electrical terminal 17 may change when FOD is present at the separable connector interface 12 compared to when no foreign object is present at the separable connector interface 12. For example, if the FOD is made from a different material than the electrical terminal 17 then the electrical resistance may change, which may be indicative of presence of the FOD. If the FOD is made from a dielectric material, such as plastic or rubber, then the FOD is nonconductive and the electrical connection between the pogo pin 118 and the electrical terminal 17 is lost, indicative of presence of the FOD. The connector health monitoring device 100 may be used for foreign object detection in separable interfaces.

In an exemplary embodiment, the connector health monitoring device 100 integrates various sensing or measurement techniques, such as resistance measurement and force measurement. The connector health monitoring device 100 may use the pogo pin 118 to detect the presence of foreign objects, such as by simultaneously measuring electrical resistance and applied force. In an exemplary embodiment, the pogo pin 118 is designed with an end diameter matching the socket opening for precise FOD detection. The pogo pin 118 may feature a screw-on head that is removable and replaceable to accommodate specific geometries. The pogo pin 118 can be made of plastic for FOD-only applications or can be made of metal for combined FOD and electrical measurements. In other various embodiments, the testing probe 110 may be used to measure other characteristics, such as mating force, contact wear, or other characteristics to assess the health of the testable contact and/or the housing of the electrical connector 10.

In an exemplary embodiment, the testing probe 110 may measure emissivity of the testable contact to assess health of the testable contact. For example, the corresponding testing sensor 120 may measure how efficiently the surface of the testable contact emits thermal radiation. The emissivity measurement may define testing data that is transmitted by the communication module 166, such as to the health assessment device 200, to determine contact wear. In other various embodiments, the control module 164 may use the emissivity measurement to determine contact wear. For example, based on the emissivity difference between silver and copper, the control module 164 may predict the amount of wear on the mating interface surface of the testable contact, such as to determine if maintenance is required. The control module 164 may perform a projected area analysis for more accurate wear assessment.

In an exemplary embodiment, the connector health monitoring device 100 may integrate the testing probe 110 into a connector design, such as into the charging inlet or charging plug used for charging, such as electric vehicle charging. The connector health monitoring device 100 may leverage the testing properties to automatically assess the connector health, such as the health of the contacts and/or to detect the presence of FOD before full mating occurs. The testing probe 110 may be carefully calibrated to make contact with the testable contact for accurate assessment of the health of the testable contact. The assessment mechanism can be implemented through various means, such as electrical resistance measurement, mechanical pressure sensors, or optical sensors monitoring the connection. The automated testing approach eliminates the need for visual inspection, provides real-time feedback, and significantly reduces the risk of connector damage or system malfunction due to poor connector health.

The connector health monitoring device 100 offers several advantages. It may provide improved accuracy by combining FOD detection with resistance and force measurement, offering a more comprehensive analysis of the interface condition. In various embodiments, the connector health monitoring device 100 may include a camera (not shown) for imaging the electrical connector 10. The images from the camera may define testing data and may be analyzed for the health assessment. The design's versatility allows for both FOD-only applications and combined FOD/electrical measurement applications. The system's customizability enables adaptation to various interface geometries. The connector health monitoring device 100 provides multi-parameter analysis capability to allow it to differentiate between various types of foreign objects and interface conditions by correlating pin position, electrical continuity, and applied force. The connector health monitoring device 100 performs health assessment in separable interfaces to offer a significant improvement over existing methods by providing a multi-faceted analysis of the interface condition. The integration of resistance and force measurement capabilities alongside FOD detection enables more accurate and reliable identification of potential issues in critical connections. In various embodiments, imaging analysis may additionally be utilized to further improve the health assessment analysis.

The connector health monitoring device 100 can be a separate handheld testing device. In other various embodiments, the connector health monitoring device 100 can be integrated into the connectors at the connector interface, such as into the charging inlet or charging plug. The connector health monitoring device 100 may be integrated into various types of connector systems and is not limited to use in electric vehicle charging. The connector health monitoring device 100 can be used for detection at OEM assembly, by service technicians, or by tier I/II suppliers. The connector health monitoring device 100 can be used for FOD detection by a user, such as by a cellphone or other mobile device interface. In various embodiments, the connector health monitoring device 100 may be integrated into assembly robots. For example, the connector health monitoring device 100 may be integrated into robot end effectors that are able to test interfaces during assembly. For example, the robot end effector may check for FOD before assembling connectors in high pollution environments.

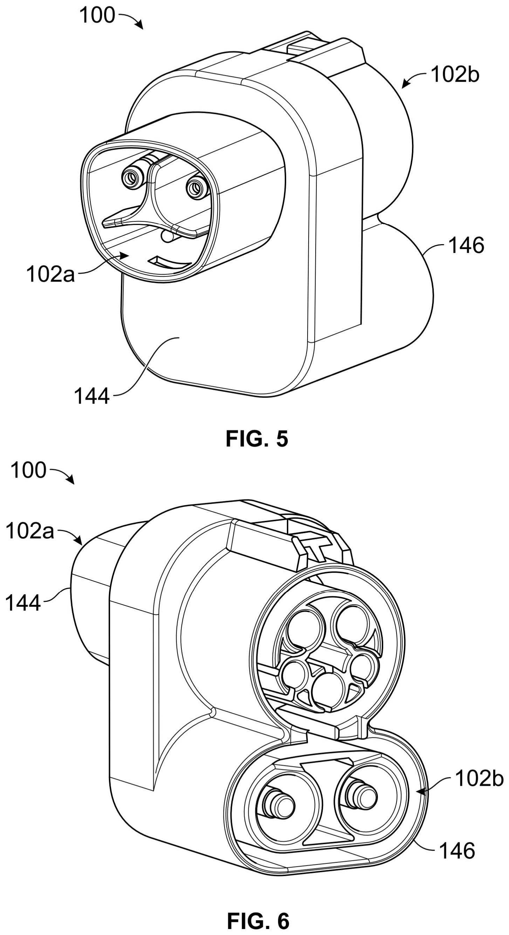

Figure 5 is a front perspective view of the connector health monitoring device 100 in accordance with an exemplary embodiment. Figure 6 is a rear perspective view of the connector health monitoring device 100 shown in Figure 5. In the illustrated embodiment, the connector health monitoring device 100 includes a first mating interface 102a at the front 144 and a second mating interface 102b at the rear 146. The first mating interface 102a may be a NACS charging interface and the second mating interface 102b may be a CCS1 charging interface. Other types of interfaces may be used in alternative embodiments. Providing different types of mating interfaces on the same connector health monitoring device allows testing of different types of electrical connectors using the same connector health monitoring device.

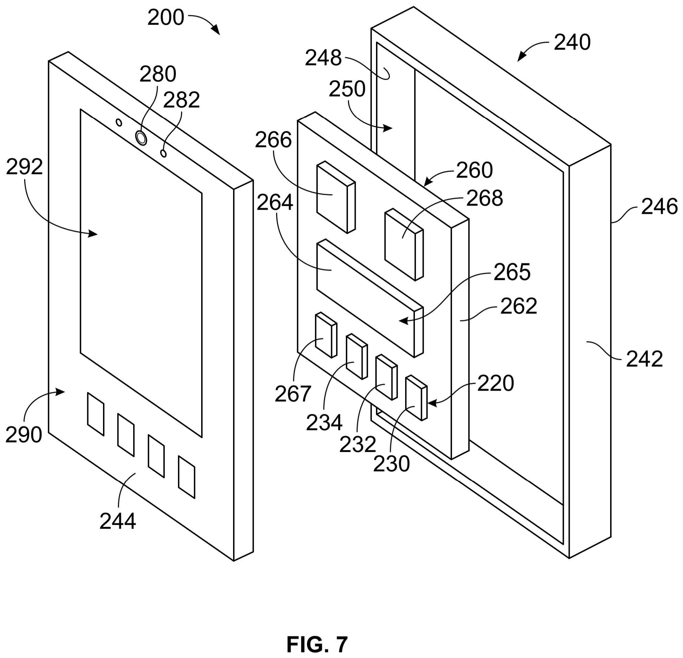

Figure 7 is a front view of the health assessment device 200 in accordance with an exemplary embodiment. The health assessment device 200 includes a device housing 240 holding an analysis module 260 for performing a health assessment of the electrical connector based on the testing data. The health assessment device 200 is configured to communicate with the connector health monitoring device 100 and receives the testing data from the connector health monitoring device 100. The analysis module 260 may include one or more processors for processing the testing data. The analysis module 260 may include one or more sensors for receiving the testing data and analyzing the testing data. The health assessment device 200 is configured to generate an output indicative of the health assessment of the electrical connector 10. The output may be displayed or indicated at the health assessment device 200. The output may be transmitted back to the connector health monitoring device 100. The output may be transmitted to a system or component associated with the electrical connector 10 (for example, the charging system or the vehicle or the assembly robot). The output may be transmitted to another remote device, computer, server, network, cloud, or other recipient. The output may be used to allow/disallow connection or operation of the electrical connector, for scheduled maintenance of the electrical connector, to evaluate efficiency (for example, power conversion efficiency to predict charging time based on use of the electrical connector 10) for the electrical connector, or for other purposes.

The device housing 240 includes a body 242 extending between a front 244 and a rear 246 of the device housing 240. In an exemplary embodiment, the body 242 may be manufactured from a dielectric material, such as a plastic material. However, the body 242 may be manufactured from other materials, such as metal. The body 242 may be a multipiece body having multiple pieces coupled together to form the device housing 240. The body 242 includes walls 248 surrounding a cavity 250. The analyzer module 260 is received in the cavity 250. Other components may be housed within the cavity 250 and surrounded by the body 242. In various embodiments, the cavity 250 may be enclosed, such as being entirely surrounded by the body 242. In various embodiments, the body 242 may be sealed to provide a sealed environment for the components held within the cavity 250.

The analyzer module 260 is configured to be held by the device housing 240 and may be received in the cavity 250. The analyzer module 260 receives the testing data from the connector health monitoring device 100. In an exemplary embodiment, the analyzer module 260 includes circuitry or components for processing the testing data. The analyzer module 260 may include circuitry or components for measuring and/or analyzing the testing data. The analyzer module 260 may include circuitry or components for performing a health assessment of the electrical connector 10 during the testing operation.

In an exemplary embodiment, the analyzer module 260 includes a printed circuit board 262, a control module 264 mounted to the printed circuit board 262 and a communication module 266 coupled to the printed circuit board 262. The analyzer module 260 may include a geolocation element 267 to identify a location of the health assessment device 200 during testing, such as using GPS or other location based tracking device, such as to identify the location of the electrical connector being tested. In an exemplary embodiment, the analyzer module 260 may include a battery 268 for powering one or more components of the analyzer module 260. The battery 268 is configured to be positioned in the cavity 250 of the device housing 240. The battery 268 may be rechargeable.

In an exemplary embodiment, the health assessment device 200 includes a user interface 290 coupled to the device housing 240. The user interface 290 is coupled to the printed circuit board 262 and/or the analyzer module 260 and may receive the output from the analyzer module 260 to provide the output to the user. The user interface 290 may be provided at the front of the device housing 240. The user interface 290 includes a display 292 configured to display information to the user, such as operational status, data indicative of the health assessment, communication status, battery status, or other information for easy interpretation of test results and device status. In various embodiments, the display 292 may be a touch screen to allow control by the user. In other various embodiments, the user interface 290 may include other inputs, such as a keypad, buttons, sliders, dials, or other types of user inputs. In alternative embodiments, the user inputs may be made through a remote device, such as a mobile device communicatively coupled to the health assessment device 200.

The printed circuit board 262 includes a substrate having one or more layers. The printed circuit board 262 includes circuits including conductors printed on one or more layers of the substrate. The circuits may include conductors, traces, vias, pads, or other type of circuit elements. One or more electrical components may be coupled to the circuits. The substrate of the printed circuit board 262 may be secured to the device housing 240, such as using fasteners.

In an exemplary embodiment, the analyzer module 260 may include one or more testing sensors 220. For example, the testing sensors 220 may receive the testing data transmitted form the connector health monitoring device 100. The signals may be transmitted through one or more circuits of the printed circuit board 262. The testing sensors 220 may be separate components from the control module 264. In alternative embodiments, the testing sensors 220 may be integrated with the control module 264. The testing sensors 220 are used to measure one or more health assessment characteristics of the testable contact and/or the electrical connector 10. For example, the health assessment characteristics may include mating force, electrical characteristics, contact resistance, contact wear, emissivity, contact size, contact shape, presence of FOD, and the like. Optionally, multiple testing sensors 220 may be provided for testing different health assessment characteristics and/or for testing different electrical terminals or different areas of the electrical connector 10. In an exemplary embodiment, the testing arrangement is configured for multi-parameter health assessment analysis of the electrical connector 10. The testing sensor 220 may be a force sensor configured to measure mating forces at the testing probe 110. The testing sensor 220 may be an electrical sensor configured to measure current, voltage, amperage, and the like. The testing sensor 220 may be a proximity sensor configured to measure proximity and/or distance to the testable contact or other component of the electrical connector. The testing sensor 220 may be an image sensor configured to analyze digital images or other types of images.

The control module 264 includes one or more electrical components, such as processors, IC components, memory devices, a CMOS sensor, a field programmable gate array (FPGA), a digital signal processor (DSP), and the like. For example, the control module 264 includes one or more processors 265 for processing the testing data. In an exemplary embodiment, the control module 264 may be programmable. For example, the control module 264 may receive over-the-air update signals, such as to update the analysis software or algorithms. During operation, the control module 264 may run programs to process the testing data and/or analyze the testing data, such as for health assessment. For example, the control module 264 operates programs stored in one or more memories on the processor 265. The data analysis may be used to allow/disallow connection or operation of the electrical connector, for scheduled maintenance, to evaluate efficiency (for example, power conversion efficiency to predict charging time based on use of the electrical connector 10).

The processor(s) 265 may include computer system executable instructions, such as program modules, being executed by a computer system. Generally, program modules may include routines, programs, objects, components, logic, data structures, and so on that perform particular tasks or implement particular abstract data types. The computing may be practiced in distributed cloud computing environments where tasks are performed by remote processing devices that are linked through a communications network. In a distributed cloud computing environment, program modules may be located in both local and remote computer system storage media including memory storage devices.

In an exemplary embodiment, various components may be communicatively coupled by a bus, such as the memory and the processors 265. The bus represents one or more of any of several types of bus structures, including a memory bus or memory controller, a peripheral bus, an accelerated graphics port, and a processor or local bus using any of a variety of bus architectures.

The control module 264 may include a variety of computer system readable media. Such media may be any available media that is accessible by the control module 264, and it includes both volatile and non-volatile media, removable and non-removable media. The memory can include computer system readable media in the form of volatile memory, such as random access memory (RAM) and/or cache memory. The control module 264 may further include other removable/non-removable, volatile/non-volatile computer system storage media. By way of example only, a storage system can be provided for reading from and writing to a non-removable, non-volatile magnetic media (not shown and typically called a "hard drive"). Although not shown, a magnetic disk drive for reading from and writing to a removable, non-volatile magnetic disk (e.g., a "floppy disk"), and an optical disk drive for reading from or writing to a removable, non-volatile optical disk such as a CD-ROM, DVD-ROM or other optical media can be provided. In such instances, each can be connected to the bus by one or more data media interfaces. The memory may include at least one program product having a set (e.g., at least one) of program modules that are configured to carry out the functions of embodiments of the invention.

One or more programs may be stored in the memory, as well as an operating system, one or more application programs, other program modules, and program data. Each of the operating system, one or more application programs, other program modules, and program data or some combination thereof, may include an implementation of a networking environment. Program modules generally carry out the functions and/or methodologies of embodiments of the subject matter described herein.

The control module 264 may also communicate with one or more external devices, such as through the communication module 266 of the control module 264, for data sharing and/or analysis by remote testing devices. In an exemplary embodiment, the communication module 266 communicates with the communication module 166 of the connector health monitoring device 100. For example, the communication module 266 may receive the testing data from the connector health monitoring device 100 and/or may transmit the health assessment output or other data to the connector health monitoring device 100. The communication module 266 may communicate with the electrical connector 10 or the system incorporating the electrical connector 10 (for example, the charging station or the electric vehicle). The communication module 266 may communicate with the user, such as through a mobile device (for example, cell phone app or vehicle display system). In various embodiments, the communication module 266 is configured to communicate wirelessly, such as via Bluetooth, Wi-Fi, cellular, or other wireless protocol. The health data or other signals may be shared with the electrical connector, or the system associated with the electrical connector, for maintenance or to alert other users of the health of the electrical connector. The external devices may include a keyboard, a pointing device, a display, and the like; one or more devices that enable a user to interact with system; one or more mobile devices (such as a mobile phone or mobile testing unit); one or more devices associated with the electrical connector 10 (such as the charging station, the electric vehicle, and the like); and/or any devices (e.g., network card, modem, etc.) that enable the system to communicate with one or more other computing devices. Such communication can occur via Input/Output (I/O) interfaces. Still yet, the control module 264 can communicate with one or more networks such as a local area network (LAN), a general wide area network (WAN), and/or a public network (e.g., the Internet) via network adapter. Other hardware and/or software components could be used in conjunction with the system components shown herein. Examples include, but are not limited to: microcode, device drivers, redundant processing units, and external disk drive arrays, RAID systems, tape drives, and data archival storage systems, etc.

Computer software including instructions or code for performing the methodologies of the subject matter herein may be stored in one or more of the associated memory devices (for example, ROM, fixed or removable memory) and, when ready to be utilized, loaded in part or in whole (for example, into RAM) and implemented by a CPU. Such software could include, but is not limited to, firmware, resident software, microcode, and the like. It should be noted that any of the methods described herein can include an additional step of providing a system comprising distinct software modules embodied on a computer readable storage medium; the modules can include, for example, any or all of the appropriate elements depicted in the block diagrams and/or described herein; by way of example and not limitation, any one, some or all of the modules/blocks and or sub-modules/sub-blocks described. The method steps can then be carried out using the distinct software modules and/or sub-modules of the system, as described above, executing on one or more hardware processors. Further, a computer program product can include a computer-readable storage medium with code adapted to be implemented to carry out one or more method steps described herein, including the provision of the system with the distinct software modules.

In an exemplary embodiment, the testing sensors 220 associated with the control module 264 includes a force measurement sensor 230 for sensing mating force with the separable connector interface 22. The force measurement sensor 230 may sense a compression force of the pogo pin 118, such as to detect for FOD.

In an exemplary embodiment, the testing sensors 220 associated with the control module 264includes an electrical resistance measurement sensor 232 for sensing electrical resistance with the separable connector interface 22, such as the testable contact. The electrical resistance measurement sensor 232 senses electrical resistance between the pogo pin 118 and the testable contact.

In an exemplary embodiment, the testing sensors 220 associated with the control module 264 includes a position measurement sensor 234 for sensing a mated position of the testing probe 110 with the separable connector interface 22. The position measurement sensor 234 may include at least one of an optical sensor, a laser measurement sensor, and a proximity sensor for sensing the mated position of the testing probe 110 with the separable connector interface 22. For example, the proximity detection may communicate with the electrical connector 10 and/or the system associated with the electrical connector 10 (for example, the electric vehicle supply equipment), confirming the presence of the testing device. The position measurement sensor 234 may detect a position of the testing probe 110 relative to the testable contact and/or the housing of the electrical connector 10, such as the position of the pogo pin 118. The position measurement sensor 234 may detect a length of the pogo pin 118 and/or an amount of compression of the pogo pin 118.

In an exemplary embodiment, the health assessment device 200 includes a camera 280 for imaging the electrical connector 10. The camera 280 is operably coupled to the analyzer module 260, such as to the control module 264. For example, the images from the camera may be transmitted to the analyzer module 260. The images from the camera 280 may be analyzed by the analyzer module 260 to provide a health assessment of the electrical connector 10. For example, the images may be analyzed to identify the positions of the testable contacts relative to each other or relative to the connector housing. The images may be analyzed to determine the size of the testable contacts and/or the spacing between the testable contacts and the connector housing. The images may be analyzed to identify FOD at the mating interface. The images may be analyzed to identify damage, wear, or other problems with the testable contacts. The images may be used in addition to other testing signals of the testing probes 110 to provide the health assessment of the electrical connector 10. The images from the camera may be used for positioning of the connector health monitoring device 100 relative to the electrical connector 10. For example, for automated testing (for example, connector health monitoring device 100 incorporated into an end effector of an assembly robot), the images may be used to align the connector health monitoring device 100 with the electrical connector 10 during testing. Other types of alignment mechanisms may be used for aligning the components or for aligning the camera 280 with the mating interface, such as a laser alignment mechanism, a proximity detector, and the like.

The analyzer module 260 may use an image processing module and/or image processing algorithm and/or image processing software to analyze the image. The image processing may include boundary detection, color detection, lighting detection, image segmentation, edge detection, color mapping, feature extraction, image enhancement, color space conversion, illumination correction, and the like. The images may be analyzed by the analyzer module 260 or may be analyzed by a remote device. For example, the images may be transmitted to another device and/or the cloud for analysis offline. The analyzer module 260 or other device used for analysis may include an AI learning module for enhanced or improved imaging analysis based on the images.

During use, the camera 280 is positioned to view the components of the electrical connector 10, such as the testable contacts, the housing, or other parts of the electrical connector 10. The images may be analyzed to identify FOD in the housing and/or around the contacts, damaged or missing contacts, damaged portions of the housing, or other elements that may affect the health of the electrical connector 10. The images may be analyzed to observe or predict wear of the contacts. The images may be analyzed to look for soot, plastic, or other debris on the contacts that could affect electrical conductivity of the contacts.

In an exemplary embodiment, the health assessment device 200 includes a lighting element 282 held by the device housing 240. The lighting element 282 is configured to illuminate the electrical connector 10, such as the testable contact, the housing, or other components of the electrical connector 10. The lighting element 282 is used to improve the imaging by the camera 280. The lighting element 282 may measure ambient lighting to determine an intensity, color, or other lighting characteristic to enhance the imaging by the camera 280.

In an exemplary embodiment, the health assessment device 200 integrates various sensing or measurement techniques, such as resistance measurement and force measurement. The health assessment device 200 may additionally or alternatively use testing data in the form of images from the camera 280 of the health assessment device 200 to perform the health assessment. The camera 280 may alternatively be integrated with the connector health monitoring device 100 to image the electrical connector 10 during the testing process. The health assessment device 200 offers several advantages. It may provide improved accuracy by combining FOD detection with resistance and force measurement and/or image processing to offer a more comprehensive analysis of the interface condition. The design's versatility allows for both FOD-only applications and combined FOD/electrical measurement applications. The system's customizability enables adaptation to various interface geometries. The health assessment device 200 provides multi-parameter analysis capability to allow it to differentiate between various types of foreign objects and interface conditions by correlating pin position, electrical continuity, and applied force. The health assessment device 200 performs health assessment at separable interfaces to offer a significant improvement over existing methods by providing a multi-faceted analysis of the interface condition. The integration of resistance and force measurement capabilities alongside FOD detection enables more accurate and reliable identification of potential issues in critical connections. In various embodiments, imaging analysis may additionally be utilized to further improve the health assessment analysis.

The health assessment device 200 can be a separate handheld device. In other various embodiments, the health assessment device 200 can be integrated into the electrical connectors 10 or system components associated with the electrical connectors 10, such as into the charging inlet or charging plug or the assembly robot. The health assessment device 200 may be integrated into various types of connector systems and is not limited to use in electric vehicle charging. The health assessment device 200 can be used for detection at OEM assembly, by service technicians, or by tier I/II suppliers. The health assessment device 200 can be used for FOD detection by a user, such as by a cellphone or other mobile device interface. In various embodiments, the health assessment device 200 may be integrated into assembly robots. For example, the health assessment device 200 may be integrated into robot end effectors that are able to test interfaces during assembly. For example, the robot end effector may check for FOD before assembling connectors in high pollution environments.

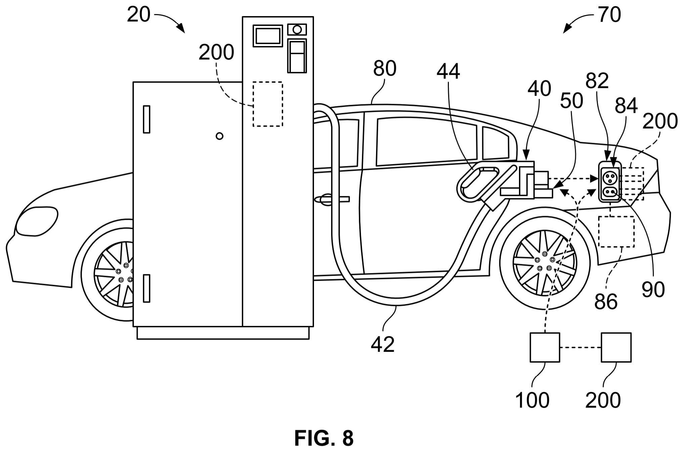

Figure 8 illustrates the connector health monitoring system 70 in accordance with an exemplary embodiment. The connector health monitoring system 70 includes the connector health monitoring device 100 and the health assessment device 200. The monitoring device 100 is used for monitoring health of charging terminals used for charging an electric vehicle 80. The connector health monitoring system 70 measures charging interface health when the vehicle 80 is connected to a charging station 20.

The connector health monitoring system 70 may be used to detect for presence of foreign objects at the charging interface before charging occurs and/or during charging. The connector health monitoring system 70 may be used to assess health of the charging terminals at the charging interface before charging occurs and/or during charging. The connector health monitoring system 70 may provide a signal that allows or disallows charging based on the measured health of that particular separable interface and/or based on FOD detection. The connector health monitoring system 70 reduces dissatisfaction with low charging rates, the potential for harmful user intervention (jiggling the charging plug to increase charging rate) or damage to the inlet and charging plug due to poor interface health.

Components of the connector health monitoring system 70 may be incorporated into the electric vehicle 80 and/or the charging station 20 for charging the electric vehicle 80 to monitor health of the charging components, such as to control the charging operation. For example, the connector health monitoring device 100 may be incorporated into the electric vehicle 80 and/or the charging station 20. Additionally or alternatively, the health assessment device 200 may be incorporated into the electric vehicle 80 and/or the charging station 20. The connector health monitoring system 70 may allow or disallow the charging operation based on the health of the charging terminals and/or based on FOD detection. In an exemplary embodiment, the connector health monitoring system 70 measures interface resistance at the interface of the charging terminals to determine a health of the charging components and/or to detect presence of FOD. If the interface resistance is too high, the connector health monitoring system 70 may disallow the charging operation leading the operator to use a different charging station 20 and/or to repair or replace the charging components to improve the charging operation.

The electric vehicle 80 includes a charging inlet 82 having charging terminals 90. In an exemplary embodiment, the charging inlet 82 includes a receptacle configured to receive a charging plug. In various embodiments, the charging inlet 82 is operable as a standard type charging inlet, such as an SAE J1772 inlet. In an exemplary embodiment, the charging terminals 90 are pin terminals. However, other types of charging terminals may be used in alternative embodiments. The charging inlet 82 is mounted to the vehicle 80. The charging inlet 82 is electrically connected to a battery 86 of the electric vehicle 80. The charging terminals 90 are supplied power from the charging station 20 to recharge the battery 86. The connector health monitoring device 100 may be integrated into the charging inlet, such as being integrated with the charging terminals 90.

The charging station 20 includes a charging plug 40 at an end of a charging cable 42. The charging plug 40 is configured to be mated with the charging inlet 82. The charging station 20 supplies power to the charging plug 40 to charge the electric vehicle 80. The charging plug 40 may be a Level 1 charger, a Level 2 charger or a Level 3 charger. In an exemplary embodiment, the charging plug may be a DC fast charging plug. The charging plug 40 may be any type of electric vehicle charging interface having an arrangement of charging terminals, such as a combined charging system (CCS) having both AC charging terminals and DC charging terminals. The charging plug 40 includes a handle 44 holding charging terminals 50. In an exemplary embodiment, the charging terminals 50 are charging sockets. The charging terminals 50 are configured to be received in the receptacle 84 to mate with the charging terminals 90 of the charging inlet 82.

In various embodiments, the connector health monitoring device 100 may be part of the electric vehicle 80. For example, the connector health monitoring device 100 may be part of the charging inlet 82. The connector health monitoring device 100 may be part of the battery system. Additionally or alternatively, the health assessment device 200 may be part of the electric vehicle 80. For example, the health assessment device 200 may be part of the charging inlet 82. The health assessment device 200 may be part of the battery system. In other various embodiments, the connector health monitoring device 100 may be part of the charging station 20. For example, the connector health monitoring device 100 may be part of the charging plug 40. Additionally or alternatively, the health assessment device 200 may be part of the charging station 20 For example, the health assessment device 200 may be part of the charging plug 40.

The connector health monitoring system 70 may control the power supply from the charging station 20 to the charging inlet 82. For example, the connector health monitoring system 70 may shut off the charging operation if the health of the charging components at the charging interface is determined to be unhealthy and/or if FOD is detected. For example, if there is high electrical resistance at the charging interface, such as due to damage or deterioration or due to the presence of foreign objects, the charging operation may be disallowed. In an exemplary embodiment, the connector health monitoring system 70 enables individual consumers, fleet owners, charging station maintenance contractors, or other individuals to assess the health of the charging plug 40 and determine if any maintenance and/or replacement of the charging plug 40 or components thereof is required. The connector health monitoring system 70 measures the resistance of the connection in the charging plug 40 to determine the health of the charging terminals 50. In an exemplary embodiment, the connector health monitoring system 70 compares the measured resistance with a known database of connections ranging from good to poor and provides the user with an indication of health of the particular charging terminals 50 to determine if the charging terminals 50 need service or replacement. The connector health monitoring system 70 may provide an output to the user indicative of the health of the charging terminals 50 and/or the presence of FOD, which may be displayed at the charging station 20 and/or within the electric vehicle 80 and/or at a mobile device.

Embodiments described herein may have safety features incorporated into the design. For example, the products may be designed to prevent high voltage on the tester (for example, on the connector health monitoring device 100). For example, the connector health monitoring device 100 may have certain components removed to restrict high voltage flow at the interface. For example, the control pilot and/or the proximity pilot and/or the protective earth terminals may be eliminated at the mating interface so that the tester does not go into a state that would represent a vehicle and thus high voltage charging does not occur during testing.

Embodiments of the invention are also described in the following numbered clauses:
Clause 1. A connector health monitoring system for health assessment testing of an electrical connector, the connector health monitoring system comprising:
   a connector health monitoring device including a device housing and a testing probe held by the device housing, the device housing including a mating end configured for mating with the electrical connector, the testing probe arranged at the mating end for mating with a testable contact of the electrical connector to generate testing data, the connector health monitoring device including a communication module configured to transmit the testing data; and
   a health assessment device communicatively coupled to the connector health monitoring device, the health assessment device including a communication module configured to receive the testing data from the communication module of the connector health monitoring device, the health assessment device including an analyzer module including a processor for performing a health assessment of the electrical connector based on the testing data.
Clause 2. The connector health monitoring device or system of Clause 1, wherein the health assessment device is separate and discrete from the connector health monitoring device.
Clause 3. The connector health monitoring device or system of Clause 1 or 2, wherein the testing data is transmitted to the health assessment device by the connector health monitoring device prior to processing the testing data.
Clause 4. The connector health monitoring device or system of Clause 1 or 2, wherein the connector health monitoring device includes one or more processors for processing the testing data, the processed testing data being transmitted to the health assessment device for analysis.
Clause 5. The connector health monitoring device or system of any preceding Clause, wherein the health assessment device is a handheld mobile device.
Clause 6. The connector health monitoring device or system of any preceding Clause, wherein the health assessment device is a system component associated with the electrical connector.
Clause 7. The connector health monitoring device or system of any preceding Clause, wherein the electrical connector is a charging plug of the charging station, the health assessment device being integrated with the charging station.
Clause 8. The connector health monitoring device or system of any preceding Clause, further comprising an assembly robot having a robot arm and an end effector at an end of the robot arm, the connector health monitoring device held by the end effector, the health assessment device integrated with a control module of the assembly robot.
Clause 9. The connector health monitoring device or system of any preceding Clause, wherein the health assessment device generates an output based on the health assessment.
Clause 10. The connector health monitoring device or system of Clause 9, wherein the health assessment device includes a user interface having a display, the output being represented on the display.
Clause 11. The connector health monitoring device or system of Clause 9 or 10, wherein the health assessment device transmits the output to a remote monitoring system.
Clause 12. The connector health monitoring device or system of any preceding Clause, wherein the analyzer module of the health assessment device performs a predictive analysis of an operational characteristic of the electrical connector.
Clause 13. The connector health monitoring device or system of Clause 12, wherein the operational characteristic is a charging time based on the health assessment of the electrical connector.
Clause 14. The connector health monitoring device or system of any preceding Clause, wherein the communication module of the connector health monitoring device is configured to communicate by short range wireless communication with the health assessment device in a vicinity of the connector health monitoring device.
Clause 15. The connector health monitoring device or system of any preceding Clause, wherein the communication module of the connector health monitoring device is configured to communicate by cellular wireless communication through a cellular network with the health assessment device.
Clause 16. The connector health monitoring device or system of any preceding Clause, wherein the analyzer module includes a neural network for machine learning based on the testing data.
Clause 17. The connector health monitoring device or system of any preceding Clause, further comprising a camera for imaging the mating interface of the electrical connector, the camera generating images, the analyzer module performing the health assessment based on the testing data and the images.
Clause 18. The connector health monitoring device or system of any preceding Clause, wherein the camera is integrated with the connector health monitoring device.
Clause 19. The connector health monitoring device or system of any preceding Clause, wherein the camera is integrated with the health assessment device.
Clause 20. The connector health monitoring device or system of any preceding Clause, wherein further comprising a lighting element configured to illuminate the mating interface for imaging.
Clause 21. The connector health monitoring device or system of any preceding Clause, wherein the connector health monitoring device includes a position sensor for determining a position of the connector health monitoring device relative to the electrical connector.
Clause 22. The connector health monitoring device or system of Clause 21, wherein the position sensor is a proximity detector.
Clause 23. The connector health monitoring device or system of any preceding Clause, further comprising a geolocation device configured to generate a geolocation tag, the geolocation device associated with one of the connector health monitoring device or the health assessment device, the geolocation tag associated with the health assessment.
Clause 24. The connector health monitoring device or system of any preceding Clause, wherein the analyzer module receives over the air signals to update the analyzer module for performing the health assessment.
Clause 25. The connector health monitoring device or system of any preceding Clause, wherein the testing probe is configured to test at least one of a force measurement, a size measurement, and electrical characteristics of the testable contact.
Clause 26. The connector health monitoring device or system of any preceding Clause, wherein the device housing includes walls forming a socket at the mating end, the testing probe located in the socket.
Clause 27. The connector health monitoring device or system of any preceding Clause, wherein the testing probe is a first testing probe, the connector health monitoring device further comprising a second testing probe at the mating end for mating with a second testable contact of the electrical connector.
Clause 28. The connector health monitoring device or system of any preceding Clause, wherein the mating end is a first mating end at a first side of the dielectric housing, the dielectric housing including a second mating end at a second side of the dielectric housing, the connector health monitoring device further comprising a second testing probe at the second mating end, wherein the first mating end has a first layout for mating with a first type of electrical connector and the second mating end has a second layout for mating with a second type of electrical connector.
Clause 29. The connector health monitoring device or system of any preceding Clause, further comprising a user interface coupled to the device housing, the user interface optionally comprising a display, for example a touchscreen.
Clause 30. The connector health monitoring device or system of any preceding Clause, wherein the analyzer module includes a first sensor for sensing a first health assessment characteristic of the testable contact and a second sensor for sensing a second health assessment characteristic of the testable contact different from the first health assessment characteristic.
Clause 31. The connector health monitoring device or system of any preceding Clause, wherein the testing probe includes a pogo pin configured to interface with the testable contact to test at least one of a mating force with the testable contact and an electrical resistance with the testable contact.
Clause 32. The connector health monitoring device or system of any preceding Clause, wherein the testing probe monitors for foreign object(s) at the mating interface with the testable contact.
Clause 33. A connector health monitoring system for health assessment testing of a charging connector for an electric vehicle, the connector health monitoring system comprising:
   a connector health monitoring device including a device housing and a testing probe held by the device housing, the device housing including a mating end configured for mating with the charging connector, the testing probe arranged at the mating end for mating with a charging contact of the charging connector to generate testing data, the connector health monitoring device including a communication module configured to transmit the testing data; and
   a health assessment device communicatively coupled to the connector health monitoring device, the health assessment device including a communication module configured to receive the testing data from the communication module of the connector health monitoring device, the health assessment device including an analyzer module including a processor for performing a health assessment of the electrical connector based on the testing data.
Clause 34. A method of monitoring health of a separable connector interface of an electrical connector, the method comprising:
   providing a connector health monitoring device including a device housing and a testing probe held by the device housing, the device housing including a mating end configured for mating with the electrical connector, the testing probe arranged at the mating end, the connector health monitoring device including a communication module;
   mating the testing probe with a testable contact of the electrical connector at the separable connector interface;
   measuring a health assessment characteristic of the testable contact with the testing probe and generating testing data;
   transmitting the testing data from the connector health monitoring device to
      a health assessment device; and
   generating a health assessment of the testable contact at the health assessment device based on the measured health assessment characteristic.
Clause 35. The method of Clause 34, further comprising transmitting the health assessment to a remote device.
Clause 36. The method of Clause 34 or 35, further comprising imaging the testable contact with a camera prior to mating the testing probe with the testable contact, said generating a health assessment at the control element of the testable contact is based on images of the testable contact.

## Claims

1. A connector health monitoring system (70) for health assessment testing of an electrical connector (10), the connector health monitoring system comprising:
a connector health monitoring device (100) including a device housing (140) and a testing probe (110) held by the device housing, the device housing including a mating end (112) configured for mating with the electrical connector, the testing probe arranged at the mating end for mating with a testable contact of the electrical connector to generate testing data, the connector health monitoring device including a communication module (166) configured to transmit the testing data; and
a health assessment device (200) communicatively coupled to the connector health monitoring device, the health assessment device including a communication module configured to receive the testing data from the communication module of the connector health monitoring device, the health assessment device including an analyzer module (260) including a processor (165) for performing a health assessment of the electrical connector based on the testing data.

2. The connector health monitoring system (70) of claim 1, wherein the health assessment device (200) is separate and discrete from the connector health monitoring device (100).

3. The connector health monitoring system (70) of claim 1 or 2, wherein the testing data is transmitted to the health assessment device (200) by the connector health monitoring device (100) prior to processing the testing data, or wherein the connector health monitoring device includes one or more processors (165) for processing the testing data, the processed testing data being transmitted to the health assessment device (200) for analysis.

4. The connector health monitoring system (70) of any preceding claim, wherein the electrical connector (10) is a charging plug (40) of a charging station (20), the health assessment device (200) being integrated with the charging station.

5. The connector health monitoring system (70) of any preceding claim, further comprising an assembly robot having a robot arm and an end effector at an end of the robot arm, the connector health monitoring device (200) held by the end effector, the health assessment device integrated with a control module (164) of the assembly robot.

6. The connector health monitoring system (70) of any preceding claim, wherein the analyzer module (260) of the health assessment device (200) performs a predictive analysis of an operational characteristic of the electrical connector (10).

7. The connector health monitoring system (70) of any preceding claim, wherein the communication module (166) of the connector health monitoring device is configured to communicate by wireless communication with the health assessment device (200), for example short range wireless communication or cellular wireless communication through a cellular network.

8. The connector health monitoring system (70) of any preceding claim, wherein the analyzer module (260) includes a neural network for machine learning based on the testing data.

9. The connector health monitoring system (70) of any preceding claim, further comprising a camera (280) for imaging the mating interface (102) of the electrical connector (10), the camera generating images, the analyzer module (260) performing the health assessment based on the testing data and the images.

10. The connector health monitoring system (70) of any preceding claim, wherein the connector health monitoring device includes a position sensor (234) for determining a position of the connector health monitoring device relative to the electrical connector (10).

11. The connector health monitoring system (70) of any preceding claim, further comprising a geolocation device (167) configured to generate a geolocation tag, the geolocation device associated with one of the connector health monitoring device or the health assessment device (200), the geolocation tag associated with the health assessment.

12. The connector health monitoring system (70) of any preceding claim, wherein the analyzer module (260) receives over the air signals to update the analyzer module for performing the health assessment.

13. The connector health monitoring system (70) of any preceding claim, wherein the testing probe (110) is configured to test at least one of a force measurement, a size measurement, and electrical characteristics of the testable contact.

14. The connector health monitoring system (70) of any preceding claim, wherein the mating end (112) is a first mating end at a first side of the dielectric housing, the dielectric housing including a second mating end at a second side of the dielectric housing, the connector health monitoring device further comprising a second testing probe (110) at the second mating end, wherein the first mating end has a first layout for mating with a first type of electrical connector (16) and the second mating end has a second layout for mating with a second type of electrical connector (18).

15. The connector health monitoring system (70) of any preceding claim, further comprising a user interface (290) coupled to the device housing (140).

16. The connector health monitoring system (70) of any preceding claim, wherein the analyzer module (260) includes a first sensor for sensing a first health assessment characteristic of the testable contact and a second sensor for sensing a second health assessment characteristic of the testable contact different from the first health assessment characteristic.

17. The connector health monitoring system (70) of any preceding claim, wherein the testing probe (110) includes a pogo pin (218) configured to interface with the testable contact to test at least one of a mating force with the testable contact and an electrical resistance with the testable contact.

18. The connector health monitoring system (70) of any preceding claim, wherein the testing probe (110) includes a low wear layer at the mating interface (202) to improve wear resistance, for example a graphite layer.

19. A method of monitoring health of a separable connector interface (22) of an electrical connector (10), the method comprising:
providing a connector health monitoring device (100) including a device housing (140) and a testing probe (110) held by the device housing, the device housing including a mating end (112) configured for mating with the electrical connector, the testing probe arranged at the mating end, the connector health monitoring device including a communication module (166);
mating the testing probe with a testable contact of the electrical connector at the separable connector interface (22);
measuring a health assessment characteristic of the testable contact with the testing probe and generating testing data;
transmitting the testing data from the connector health monitoring device to a health assessment device (200); and
generating a health assessment of the testable contact at the health assessment device based on the measured health assessment characteristic,
wherein the method is optionally a method of using the connector health monitoring system (70) of any preceding claim.
